# EUROPEAN PATENT APPLICATION

(11) **EP 1 909 314 A1**
(43) Date of publication of application: **09.04.2008**
(21) Application number: 07024972.7
(22) Date of filing: 29.05.1998
(51) Int. Cl.: H01L 21/306, H01L 21/311, H01L 21/00

(54) **Processing method an apparatus for removing oxide film**

(30) Priority: 04.06.1997 JP 16188197
(62) Divisional of application: 98109891.6
(71) Applicant: TOKYO ELECTRON LIMITED, Minato-ku Tokyo 107-8481 (JP)
(72) Inventor: Kobayashi, Yasuo, Minato-ku Tokyo 107-8481 (JP)
(74) Representative: HOFFMANN EITLE

(57) **Abstract**

Disclosed are a processing method and apparatus for removing a native oxide film formed on a surface of an object W. The surface of the object is exposed to activated gases formed from a N₂ gas (52), a H₂ gas (54) and a NF₃ (83) gas to bring about a reaction between the native oxide film formed on the surface of the object and the activated gases. As a result, a reaction film is formed. The reaction film thus formed is sublimated by heating (36) the object to a predetermined temperature, thereby to remove the native oxide film from the surface of the object. For forming the activated gases, the N₂ gas (52) and H₂ gas (54) are converted into a plasma and activated to form active species, followed by adding the NF₃ gas (80) to the active species to form an activated gas containing the NF₃ gas.

## Description

The present invention relates to a processing method and apparatus for removing an oxide film formed on a surface of an object to be treated mainly such as a semiconductor wafer, particularly, to a processing method and apparatus for removing a thin oxide film such as a native oxide film formed on a surface of the object such as a semiconductor wafer, and more particularly, to a processing method and apparatus for removing a native oxide film formed in a bottom portion of a fine hole formed on a surface of the object such as a semiconductor wafer.

The present invention is directed mainly to a technique of removing an oxide film formed on a surface of an object such as a semiconductor wafer, particularly, to a technique for removing a native oxide film. Although, the object to be processed in the present invention is not limited to a semiconductor wafer, the related art in relation to a technique for removing a native oxide film formed in a bottom portion of a fine hole formed on a surface region of a semiconductor wafer in order to specifically describing the related art is described.

As widely known to the art, processes to form a film on a semiconductor wafer used as a substrate and etching treatments to selectively etch the resultant film in a predetermined pattern are repeatedly carried out in the manufacture of a semiconductor integrated circuit on the semiconductor wafer. During these processes, the substrate is transferred among various processing devices. During the transfer, the substrate is exposed to the air atmosphere, with the result that the oxygen and water within the air atmosphere unavoidably cause a native oxide film to be formed on a surface of the substrate. Formation of the native oxide film causes the properties such as electrical properties of the film on a surface of the substrate to be deteriorated. Where deterioration of the film properties is undesirable in the process for forming a film on the substrate or in the etching process of the film, it is necessary to remove the native oxide film formed on the substrate.

A wet etching is one of the conventional techniques for removing the native oxide film. In the wet etching, the semiconductor substrate (wafer) having a native oxide film formed thereon is immersed in a washing liquid for removing the native oxide film. It should be noted that the line width of a wiring and the diameter of a contact hole formed in the semiconductor wafer are diminished with increase in the scale of integration and miniaturization of the semiconductor integrated circuit. For example, the diameter of the contact hole is 0.2 to 0.3 µm or less. What should be noted is that, since the contact hole has a very small diameter, the washing liquid is unlikely to enter sufficiently the contact hole. Also, the washing liquid once entering the contact hole is not likely to be easily expelled from within the contact hole because of the surface tension of the washing liquid. Under the circumstances, it is difficult for the washing liquid to remove sufficiently a native oxide film formed in a bottom portion of the contact hole.

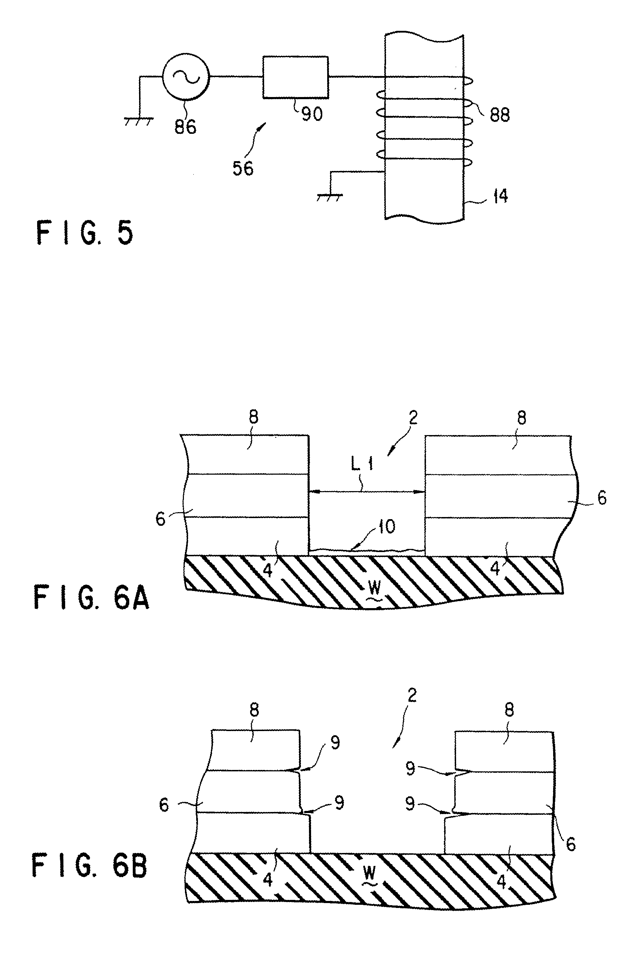

Where the substrate is subjected to a wet washing, the wall of the contact hole is also etched together with the native oxide film. It should be noted in this connection that the contact hole extends through a plurality of layers formed on the substrate, with the result that the wall of the contact hole consists of a plurality of these layers. What should be noted is that these plural layers differ from each other in the etching rate when subjected to etching with the wet washing liquid. It follows that the surface of the contact hole is rendered irregular after the etching with the wet washing liquid. FIGS. 6A and 6B show in detail the situation. Specifically, FIG. 6A shows that a contact hole 2 for achieving an electrical contact with a drain or source region is formed in a surface region of a silicon substrate W. The contact hole 2, which has a diameter of about 0.2 to 0.3 µm, extends through three layers consisting of a SiO₂ λ1 layer 4 formed by thermal oxidation, a phosphorus-doped glass (SiO₂ λ2 layer 6 formed by a spin-coating method, and a silica glass (SiO₂) λ3 layer 8, as shown in the drawing. A native oxide film 10 is formed at the bottom of the contact hole 2. These SiO₂ layers 4, 6 and 8 slightly differ from each other in the etching rate when washed with a washing liquid. It follows that, if the native oxide film 10 is removed by the wet etching, the wall surface of the contact hole 2 is caused to be irregular by the difference in the etching rate noted above, as shown in FIG. 6B. In addition, the washing liquid tends to enter the boundary regions between the adjacent two layers, leading to an over-etching of the boundary regions.

To overcome the above-noted difficulties, it is proposed to employ a so-called dry etching method in place of the wet etching method for removing the native oxide film at the bottom of the contact hole. Japanese Patent Disclosure (Kokai) No. 2-256235 discloses a method of removing a native oxide film by utilizing a NF₃ gas (halogen gas) or NH₃ gas (basic gas). It is disclosed that the halogen gas or the basic gas noted above is introduced into a process chamber, and the native oxide film is removed by plasma formed within the process chamber. In this technique, however, required is an apparatus for exhausting these two kinds of the special gases (NF₃, NH₃) leading to a high operating cost.

Japanese Patent Disclosure No. 6-338478 discloses another technique. It is disclosed that a H₂ gas and a H₂O vapor are supplied into a plasma generating section for activation of these gas and vapor. Then, a NF₃ gas or a gaseous mixture containing NF₃ gas is added to the activated gas and vapor for removing the native oxide film. However, since H₂O (steam) is used in this technique, a native oxide film tends to be formed in an amount larger than the amount of the removed native oxide film. As a matter of fact, a native oxide film was not sufficiently removed in the experiment conducted by the present inventor.

An object of the present invention, which has been achieved in an attempt to solve the above-noted problems, is to provide a method and apparatus for effectively removing an oxide film formed on a surface of an object mainly such as a semiconductor wafer.

Another object is to provide a method and apparatus for effectively removing a native oxide film formed on a surface of an object mainly such as a semiconductor wafer.

Another object is to provide a processing method and apparatus, which do not require a high cost for disposing of an exhaust gas.

Another object is to provide a method and apparatus for effectively removing a native oxide film without newly forming a native oxide film.

Further, still another object of the present invention is to provide a method and apparatus for effectively removing a native oxide film formed at a bottom portion of a fine hole formed in a surface region of an object such as a semiconductor wafer.

According to a first aspect of the present invention, there is provided a method of removing an oxide film formed on a surface of an object to be processed, comprising the steps of:
forming an activated gas from a N₂ gas, H₂ gas and NF₃ gas;
exposing a surface of the object to the activated gas to bring about a reaction between the activated gas and an oxide film formed on a surface of the object, thereby forming a reaction film; and
heating the object to a predetermined temperature so as to sublimate the reaction film.

According to a second aspect of the present invention, there is provided a processing method according to the first aspect, wherein the oxide film to be removed is a film having a thickness of generally 2 nm or less such as a native oxide film formed by the reaction with the air atmosphere.

According to a third aspect of the present invention, there is provided a processing method according to the first aspect, wherein the formation of the activated gas from the N₂ gas, H₂ gas and NF₃ gas comprises the steps of:
forming a plasma of a mixed gas consisting of the N₂ gas and H₂ gas and also forming active species; and
supplying the NF₃ gas into the active species so as to form activated gases the N₂ gas, H₂ gas and NF₃ gas.

According to a fourth aspect of the present invention, there is provided a processing method according to the third aspect, wherein the oxide film to be removed is a native oxide film formed by the reaction with the air atmosphere during predetermined process steps applied to the object.

According to a fifth aspect of the present invention, there is provided a processing method according to the third aspect, wherein the formation of a plasma of a mixed gas consisting of the N₂ gas and H₂ gas is carried out in a plasma generating section made of quartz by introducing a microwave into a mixed gas of the N₂ gas and H₂ gas supplied to the plasma generating section.

According to a sixth aspect of the present invention, there is provided a processing method according to the first aspect, wherein the predetermined temperature is at least 100°C, and each of the reaction film and the activated gas is formed at a temperature lower than 100°C.

In a preferred embodiment, the process with the activated gas is carried out at room temperature, followed by stopping the supply of the activated gas and subsequently heating the object to the predetermined temperature.

According to a seventh aspect of the present invention, there is provided a processing apparatus for removing an oxide film, comprising:
a susceptor on which an object to be processed is disposed;
a process chamber housing the susceptor; and
a mechanism for removing oxide films formed on a surface of the object;
wherein the mechanism for removing the oxide films include:
an activated gas forming device for forming an activated gas from N₂ gas, H₂ gas and NF₃ gas;
an introducing device for introducing the activated gas formed in the activated gas forming device onto a surface of the object disposed on the susceptor arranged within the process chamber; and
a heating device for heating the object to temperatures at which reaction films resulting from reaction between the oxide films formed on the surface of the object and the activated gas introduced into the process chamber are sublimated.

According to an eighth aspect of the present invention, there is provided a processing apparatus according to the seventh aspect, wherein the activated gas forming device includes:
a plasma generating device for converting the supplied gas into plasma;
a gas supply device for supplying N₂ gas and H₂ gas into the plasma generating device;
an activated species forming device for converting the plasma generated from the plasma generating device into activated species; and
an activated gas forming device for supplying an NF₃ gas into the activated species of N₂ gas and H₂ gas formed in the activated species forming device so as to form activated gases of N₂ gas H₂ gas and NF₃ gas.

According to a ninth aspect of the present invention, there is provided a processing apparatus according to the seventh aspect, wherein the oxide film formed on the surface of the object is a native oxide film formed by the reaction with the air atmosphere during the predetermined process steps applied to the object.

According to a tenth aspect of the present invention, there is provided a processing apparatus according to the ninth aspect,
wherein the activated gas forming device includes:
a plasma generating device for converting the supplied gas into plasma;
a gas supply device for supplying N₂ gas and H₂ gas into the plasma generating device;
an activated species forming device for converting the plasma generated from the plasma generating device into activated species; and
an activated gas forming device for supplying an NF₃ gas into the activated species of N₂ gas and H₂ gas formed in the activated species forming device so as to form activated gases of N₂ gas H₂ gas and NF₃ gas, and
wherein the heating device for heating the object is for heating the object to temperatures at which the native oxide films formed on the surface of the object react with the activated gas introduced into the process chamber and the resultant reaction films are sublimated.

According to an eleventh aspect of the present invention, there is provided a processing apparatus according to the tenth aspect, wherein the plasma generating device is equipped with a mechanism for converting a gas into a plasma by utilizing a microwave.

According to a twelfth aspect of the present invention, there is provided a processing apparatus according to the tenth aspect,
wherein the activated gas forming device includes:
a pipe made of microwave transmitting material; and
a supply section of a microwave and a supply section of a N₂ gas and H₂ gas formed at the inlet port of the pipe.

According to a thirteenth aspect of the present invention, there is provided a processing apparatus according to the tenth aspect, wherein an introducing mechanism for introducing the activated gas onto the surface of the object disposed on the susceptor arranged in the process chamber includes a guide arranged at the outlet port of the activated species forming device for guiding the activated gases of the N₂ gas, H₂ gas and NF₃ gas onto the surface of the object.

According to a fourteenth aspect of the present invention, there is provided a processing apparatus according to the tenth aspect, wherein those walls of the activated gas forming device, the introducing mechanism and the process chamber which are brought into contact with the activated gas are formed of an electrically insulating material.

Further, according to a fifteenth aspect of the present invention, there is provided a processing apparatus according to the tenth aspect, wherein the heating device heats the susceptor so as to elevate the temperature of the object disposed on the susceptor to temperatures at which the reaction films are sublimated.

The invention can be more fully understood from the following detailed description when taken in conjunction with the accompanying drawings, in which;
FIG. 1 shows the construction of a processing apparatus according to one embodiment of the present invention;
FIG. 2 is a plan view showing a NF₃ gas supply section;
FIGS. 3A to 3C show the processing steps of a processing method of the present invention;
FIG. 4A is a graph showing the result of an elemental analysis on a surface of an object before processing by the method of the present invention;
FIG. 4B is a graph showing the result of an elemental analysis on a surface of an object after processing by the method of the present invention;
FIG. 5 shows a modification of the plasma forming section;
FIGS. 6A and 6B are directed to a conventional method for removing a native oxide film; and
FIG. 7 is a graph showing the relationship between the contact resistance and the contact size.

The present invention is directed mainly to a technique of removing an oxide film formed on a surface of an object such as a semiconductor wafer, particularly, to a technique for removing a native oxide film. Although the object to be processed in the present invention is not limited to a semiconductor wafer, in order to specifically describing a preferred embodiment of the present invention, the present invention in relation to a technique for removing a native oxide film formed in a bottom portion of a fine hole formed on a surface region of a semiconductor wafer is described.

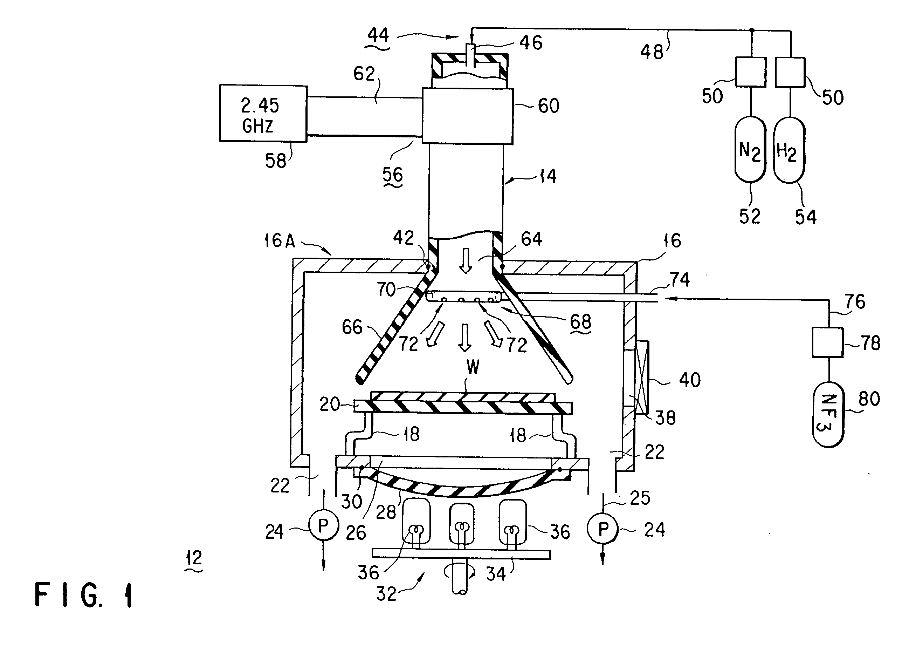

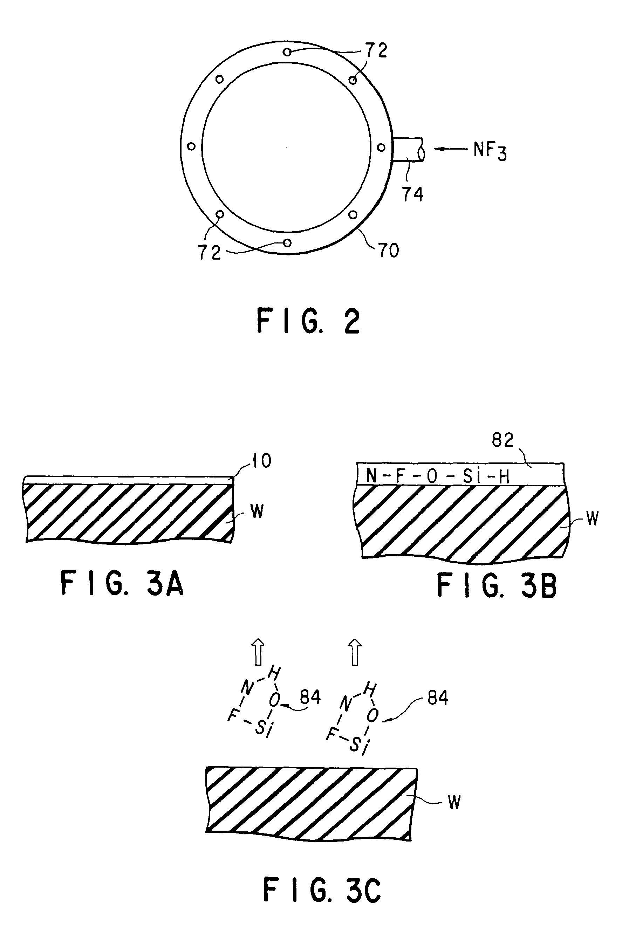

FIG. 1 shows the construction of a processing apparatus 12 of the present invention, and FIG. 2 is a plan view showing a supply section of a NF₃ gas. As shown in the drawings, the processing apparatus 12 comprises a microwave generating source 58, waveguides 60, 62, a gas introducing section 44 for introducing a mixed gas of a N₂ gas and H₂ gas, a pipe 14 for forming a plasma and active species, and a process chamber 16 in which a native oxide film formed on an object (semiconductor wafer) is removed. The microwave formed in the microwave generating source 58 is supplied through the waveguides 62, 60 and the pipe 14 for forming a plasma and active species. Within the pipe 14, the mixed gas of the N₂ gas and H₂ gas is converted into a plasma so as to form active species. The process chamber 16 is in the form of a cylinder made of, for example, aluminum. A susceptor 20 made of, for example, SiC is supported by supporting rods 18 made of, for example, quartz. Formed in a bottom portion of the process chamber 16 is an exhaust port 22, which is connected to an exhaust system 25 equipped with a vacuum pump 24, etc. for evacuating the process chamber 16. An opening 26 equal in size to the susceptor 20 is formed below the susceptor 20. A heat ray transmitting member 28 made of, for example, quartz is hermetically attached to close the opening 26 using a sealing member 30. The heat ray transmitting member 28 is shaped arcuate in cross section in a manner to bend downward in the central portion. A heating means 32 is arranged below the heat ray transmitting member 28 such that the susceptor 20 is heated from the back side. The heating means 32 includes a plurality of heating lamps 36, e.g., halogen lamps, mounted on a rotatable plate 34. The heat emitted from the heating means is transmitted through the heat ray transmitting member 28 so as to be incident on the back surface of the susceptor. Incidentally, heating means other than the heating lamps 36 shown in the drawing can also be used in the present invention. For example, it is possible to mount an electric heater within the susceptor 20. Further, a semiconductor wafer transfer port 38 and a gate valve 40 are formed in a side wall of the process chamber 16.

The pipe 14 for forming a plasma and active species, which is made of an electrically insulating and microwave transmitting material such as quarts, is hermetically mounted to close an upper opening in a ceiling portion 16A of the process chamber 16 using a sealing member 42. Also, the pipe 14 extends through the waveguide 60. The gas introducing section 44 is mounted on the upper end of the pipe 14 such that a mixed gas of a N₂ gas and a H₂ gas is introduced through the gas introducing section 44 and the waveguide 60 into the pipe 14. The gas introducing section 44 includes an introducing nozzle 46, which is connected to a gas passageway 48. The gas passageway 48 is connected to a two-way branched tube, one of the branches being connected to a N₂ gas source 52 via a flow rate controller 50, e.g., mass flow controller, and the other branch being connected to a H₂ gas source 54 via another flow rate controller 50.

The microwave having a frequency of, for example, 2.45 GHz, which is generated in the microwave generating source 58, is supplied through the waveguide 62 having, for example, a rectangular cross section, and the other waveguide 60, e.g., an Evenson type microwave, into the pipe 14 for forming a plasma and active species. The mixed gas of the H₂ gas and N₂ gas is converted into a plasma within the pipe 14 under the action of the microwave so as to form active species of 2N* from N₂ and 2H* from H₂.

An NF₃ gas supply section 68 is formed in a lower portion of an outlet port 64 of the pipe 14 so as to supply an NF₃ gas into the active species. The NF₃ gas is supplied from an NF₃ gas source 80 into a ring-like shower head 70 made of quartz through a flow rate controller 78, e.g., mass flow controller, a gas passageway 76 and a communicating pipe 74. Then, the NF₃ gas is added through a gas holes 72 to the active species. As a result, the NF₃ itself is also activated by the active species.

A guide member 66 made of quartz and downwardly flared or shaped conical is mounted to the outlet port 64 of the pipe 14 so as to permit the activated gases to be supplied uniformly onto an object to be treated.

The processing method of the present invention is worked by using the processing apparatus of the construction described above. Specifically, an object W (silicon wafer) is introduced into the process chamber 16 through the gate valve 40, which is opened, and disposed on the susceptor 20. The contact hole 2 as shown in FIG. 6A is formed in advance in a surface region of the silicon wafer W. As described previously, a native oxide (SiO₂) film 10 is formed in a bottom of the contact hole 2. FIG. 3A shows in a magnified fashion the native oxide film 10 formed in the bottom of the contact hole 2.

After introduction of the wafer W, the gate valve 40 of the process chamber 16 is closed to make the process chamber hermetic. Under this condition, the process chamber is evacuated to establish a vacuum condition. Then, the N₂ gas and H₂ gas are introduced at predetermined flow rates from the N₂ gas source 52 and the H₂ gas source 54 into the pipe 14 for forming a plasma and active species through the plasma gas introducing section 44. Also, the microwave having a frequency of, for example, 2.45 GHz, which is generated in the microwave generating source 58, is introduced into the pipe 14 through the waveguides 62 and 60. Within the pipe 14, the N₂ gas and the H₂ gas are converted by the microwave into a plasma and, activated to form active species. Since the process chamber 16 is held vacuum, these active species are moved toward the outlet port 64 of the pipe 14.

Further, the NF₃ gas supplied from the NF₃ gas source 80 is added through the ring-like shower head 70 of the NF₃ gas supply section 68 to the active species of the mixed gas of the H₂ gas and N₂ gas, with the result that the NF₃ gas is also activated by the active species so as to form a mixture of these activated gases. The mixture is effectively guided uniformly by the guide member 66 toward the wafer W so as to be brought into contact with the wafer W. As a result, the active species react with the native oxide film on the wafer W to cause the native oxide film to be modified into a reaction film 82 in which Si, N, H, F and O are mixed together, as shown in FIG. 3B. The reaction film 82 also serves to prevent the silicon wafer W itself from being etched with the activated gases. During this treatment, the wafer W is not heated, and is put under room temperature to cause the activated gases to reach a bottom of the contact hole effectively.

For example, the flow rates of the H₂ gas, N₂ gas, and NF₃ gas may be set at 20 sccm, 30 sccm and 200 sccm, respectively. The process pressure may be set at 3 Torr, the plasma power may be set at 150W, and the process time may be set at 3 minutes.

As described previously, the downwardly flared guide member 66 is arranged above the susceptor 20, with the result that scattering of the activated gases is suppressed by the guide member 66. It follows that the activated gases flow effectively toward the wafer so as to perform reaction with the native oxide film formed on the wafer W.

After formation of the reaction film 82, the supply of the H₂ gas, N₂ gas and NF₃ is stopped. Also stopped is the operation of the microwave generating source 58. Then, the process chamber 16 is evacuated to discharge the gases remaining within the process chamber 16 to the outside. Under this condition, the susceptor 20 is heated from the back surface by the heating means 32 so as to elevate the temperature of the wafer W disposed on the susceptor 20 to a predetermined level, e.g., at least 100°C. By this heating, a molecule 84 containing Si, N, H, F and O is sublimated so as to be scattered. As a result, the native oxide film 10 is removed from the wafer W to expose the Si substrate to the outside at the bottom of the contact hole. The heat treatment for removing the native oxide film 10 is carried out under a pressure of 1 mTorr or less for about 2 minutes.

The mechanism of the native oxide film removal described above has not yet been clarified sufficiently. However, it is considered reasonable to understand that the activated gases of H₂ gas, N₂ gas and NF₃ gas react with the native oxide film (SiO₂) to form a large molecule containing Si, N, H, F and O. To be more specific, N, F and H are considered to be interposed between O and Si so as to be bonded each other, and the resultant product is considered to be readily sublimated under heat of at least 100°C while maintaining a molecular form of N-F-H-O-Si.

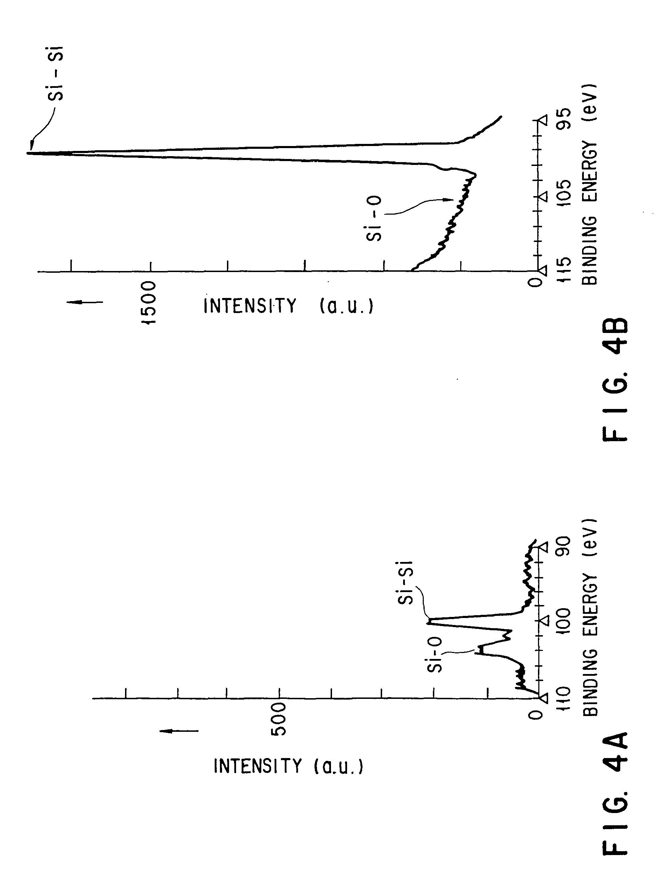

The atoms on the surface of the wafer W thus treated were analyzed by a surface elemental analysis apparatus (XPS, i.e., X-ray Photoelectron Spectroscopy), with the result as shown in FIGS. 4A and 4B. FIG. 4A shows the analytical result of the surface of the semiconductor wafer before the treatment, with FIG. 4B showing the analytical result of the wafer after the treatment of the present invention. As shown in FIG. 4A, a peak of the intensity is recognized in the vicinity of 104 eV of the binding energy, which denotes the Si-O bond, in addition to another peak in the vicinity of 99 eV of the binding energy denoting the Si-Si bond before the process of the present invention. After the process of the present invention, however, a peak is not recognized in the vicinity of 104 eV of the binding energy, which denotes the Si-O bond, though another peak is recognized in the vicinity of 99 eV of the binding energy denoting the Si-Si bond, as shown in FIG. 4B. This clearly supports that the native oxide film (SiO₂) has been completely removed by the treatment of the present invention.

Various experiments have been conducted by changing the process pressure and temperature in sublimating the reaction film 82. It has been found that the upper limit of the process pressure is about 100 mTorr. If the process pressure was higher than 100 mTorr, the reaction film 82 was not sufficiently sublimated. On the other hand, the lower limit of the process temperature has been found to be about 100°C. If the process temperature was lower than about 100°C, the reaction film 82 was not sufficiently sublimated.

If the native oxide film is removed by the conventional wet washing, the surface of the object after removal of the native oxide film is relatively roughened. However, the surface of the object after removal of the native oxide film by the method of the present invention is rendered flat, compared with the wet washing. It follows that the contact area between the wafer surface after removal of the native oxide film and the surface of the wiring fixed to the wafer surface is increased, leading to a stronger bonding between the two.

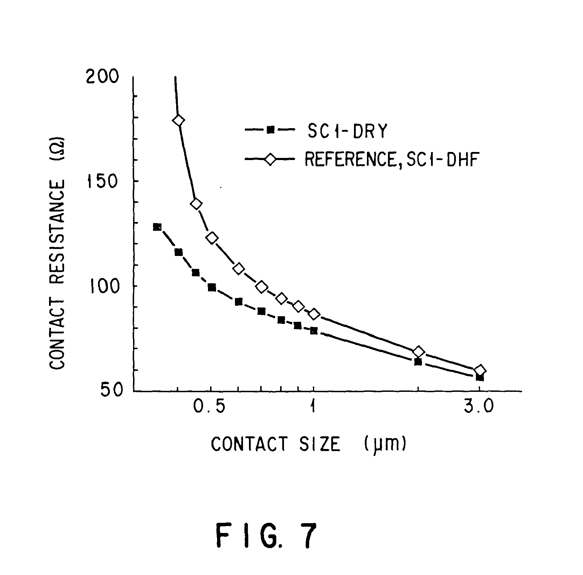

Additional experiments have been conducted in an attempt to confirm the effect produced by the present invention. In these experiment, used as samples were silicon substrates each having a silicon oxide film formed thereon. A contact hole was formed in the silicon oxide film. Further, a doped polycrystalline silicon (polysilicon) wiring was buried in the contact hole for electrical connection to the silicon substrate. Before formation of the polysilicon film, the sample was washed with a washing solution as a pretreatment in order to remove mainly particles. The washing solution consisted of ammonia water, hydrogen peroxide solution, and pure water mixed at a ratio of 1 : 2 : 10. The washing treatment was carried out at 60°C for 10 minutes. Further, each of the samples was washed with water and, then, dried, followed by dividing the samples into a group of comparative samples and another group of samples to which the method of the present invention was applied. These comparative samples were etched with an etching solution consisting of hydrofluoric acid and pure water mixed at a ratio of 1 : 99. The etching treatment was carried out at room temperature for 10 minutes. The other samples for the present invention were subjected to a dry treatment under the conditions described previously. FIG. 7 shows the experimental data in respect of the contact resistance relative to various contact sizes. The comparative samples are denoted by an SCI-DFH curve in FIG. 7, with the samples for the present invention being denoted by an SCI-DRY curve. The expression "SCI" represents the washing pretreatment which was commonly employed in both the comparative samples and the samples for the present invention. As apparent from FIG. 7, the samples treated by the method of the present invention were lower in the contact resistance than the comparative samples. In addition, the difference in the contact resistance between the comparative samples and the samples for the present invention was prominently increased with decrease in the contact size.

As described above, the processing method and apparatus of the present invention permit removing a native oxide film formed at a bottom of a fine contact hole without using a washing liquid as in the wet washing method. It should also be noted that an NH₃ gas is not used in the present invention, making it possible to disuse an exhaust gas processing apparatus for processing the NH₃ gas. It follows that the facility cost and the operating cost can be reduced in the present invention.

In the present invention, activated gases are formed from an N₂ gas, H₂ gas and NF₃ gas. A surface of an object is exposed to these activated gases to bring about a reaction between these activated gases and an oxide film to be removed, particularly a native oxide film formed on the surface of the object. As a result, the oxide film is converted into a reaction film, which is then sublimated by the heating of the object to a predetermined temperature. It should also be noted that, in the present invention, a mixed gas of a N₂ gas and H₂ gas is converted into a plasma and active species are formed. Further, the NF₃ gas is added to the active species so as to form activated gases of the N₂ gas, H₂ gas and NF₃ gas. Additional features of the present invention are as already described herein before.

It is of no difficulty for those skilled in the art to arrive at various modifications based on the embodiment of the present invention described above. Of course, these modifications fall within the technical scope of the present invention. In other words, the technical scope of the present invention is not limited to the typical embodiment described herein in detail. Needless to say, various modifications are conceivable within the technical scope defined in the appended claims.

For example, a plasma forming section 56 included in the processing apparatus of the present invention is equipped with the microwave generating source 58, the Evenson type waveguide 60, etc., as shown in FIG. 1. The plasma forming section 56 of the particular construction is efficient for forming a plasma of a mixed gas consisting of N₂ gas and H₂ gas. However, it is also possible to substitute the plasma forming section 56 constructed as shown in FIG. 5 for the plasma forming section shown in FIG. 1. To be more specific, the plasma forming section 56 shown in FIG. 5 comprises a high frequency generating source 86 generating RF (Radio Frequency) of 13.56 MHz and a induction coil 88 wound about a part of the pipe 14 for forming plasma and active species. Further, a matching circuit 90 is connected between the induction coil 88 and the high frequency generating source 86 so as to achieve the impedance matching therebetween. In this case, a plasma is formed by an inductive coupling upon supply of an RF wave to the induction coil 88, with the result that the function and effect similar to those in the embodiment described previously are exhibited.

The flow rates of the various gases described previously are no more than examples and, thus, do not limit the technical scope of the present invention.

In the embodiment described previously, the flow rates of the H₂ gas, N₂ gas and NF₃ gas are set at 20 sccm, 30 sccm and 200 sccm, respectively. However, it is possible to double these flow rates or to set the flow rates at levels higher than double of these flow rates.

Also, in the embodiment described previously, the shower head 70 for supplying the NF₃ gas is mounted to the outlet port 64 of the pipe 14 for forming plasma and active species. However, the mounting position of the shower head 70 is not limited to the outlet port 64 noted above. To be more specific, the shower head 70 can be mounted anywhere as far as the mounting position is closer to the object than the waveguide 60. In this case, it is important to add the NF₃ gas to an atmosphere of active species converted from the plasma, not to the plasma of a mixed gas consisting of H₂ gas and N₂ gas. If NF₃ is present within a plasma, the NF₃ gas is excessively activated so as to severely etch the wall made of quarts, i.e., the wall of the pipe 14 for forming plasma and active species.

Further, it is not absolutely necessary for the shower head 70 to have a ring-like structure. For example, pipes having gas holes may be arranged in a lattice shape to form the shower head. Alternatively, a simple gas introducing nozzle can be used in place of the shower head 70.

Further, the embodiment described previously is directed to removal of a native oxide film formed on a silicon substrate. Of course, the present invention can also be employed for removing a native oxide film formed on other substrates or layers. For example, the technique of the present invention can be employed for removing a native oxide film formed on a metal silicide film, e.g., film of WSiₓ, TiSiₓ, CoSiₓ, AlSiₓ or NiSiₓ.

Further, the frequencies of the microwave and RF wave are not limited to those referred to previously. In other words, the microwave and RF wave of different frequencies can also be used in the present invention.

Further, in the embodiment described previously, a native oxide film was removed within the process chamber 16. Of course, it is necessary for at least an oxide film or a native oxide film to be removed within the process chamber 16. However, it is possible to carry out other treatments such as a film-forming treatment and an etching treatment within the process chamber 16 before or after removal of the native oxide film.

Further, in the embodiment described previously, the activated gas flows downward toward a surface of an object. However, it is not absolutely necessary for the activated gas to flow downward in the present invention. For example, it is possible to allow the activated gas to flow laterally, obliquely or upwardly toward a surface of the object.

Still further, in the embodiment described previously, heating lamps arranged below the back surface of a susceptor were used as a heating means for heating an object, which was disposed on the front surface of the susceptor. Alternatively, an electric heater arranged within the susceptor may be used as the heating means. It is also possible to arrange both an electric heater and a cooling means within the susceptor. The cooling means can be used for cooling the susceptor and the object in order to permit the activated gas to be moved to reach a bottom portion of a fine hole such as a contact hole formed in a surface region of the object. Further, heating lamps arranged above the object can be used for directly heating the surface of the object.

It is of no difficulty for those skilled in the art to arrive at various modifications in respect of the features of the present invention described above. Of course, these modifications fall within the technical scope of the present invention. In other words, the technical scope of the present invention is not limited to the typical embodiment described herein in detail. Needless to say, various modifications are conceivable within the technical scope defined in the appended claims.

The invention also provides the following embodiments:
1. A method of removing an oxide film formed on a surface of an object to be processed characterized in that comprises the steps of:
   forming an activated gas from a N₂ gas, H₂ gas and NF₃ gas;
   exposing a surface of said object to said activated gas to bring about a reaction between the activated gas and an oxide film formed on a surface of the object, thereby forming a reaction film; and
   heating the object to a predetermined temperature so as to sublimate said reaction film.
2. The method according to item 1, characterized in that the oxide film to be removed is a native oxide film formed by the reaction with the air atmosphere during predetermined process steps applied to said object.
3. The method according to item 1, characterized in that the formation of the activated gas from the N₂ gas, H₂ gas and NF₃ gas comprises the steps of:
   forming a plasma of a mixed gas consisting of the N₂ gas and H₂ gas and also forming active species; and
   supplying the NF₃ gas into the active species so as to form activated gases of the N₂ gas, H₂ gas and NF₃ gas.
4. The method according to item 3, characterized in that the oxide film to be removed is a native oxide film formed by the reaction with the air atmosphere during predetermined process steps applied to the object.
5. The method according to item 3, characterized in that the formation of a plasma of a mixed gas consisting of the N₂ gas and H₂ gas is carried out in a plasma generating section by introducing a microwave into a mixed gas of the N₂ gas and H₂ gas supplied to the plasma generating section.
6. The method according to item 1, characterized in that said predetermined temperature is at least 100°C, and each of said reaction film and said activated gas is formed at a temperature lower than 100°C.
7. A processing apparatus for removing an oxide film characterized in that comprises
   a susceptor on which an object to be processed is disposed;
   a process chamber housing said susceptor; and
   a mechanism for removing oxide films formed on a surface of the object;
   wherein said mechanism for removing the oxide films include:
   an activated gas forming device for forming an activated gas from N₂ gas, H₂ gas and NF₃ gas;
   an introducing device for introducing the activated gas formed in said activated gas forming device onto a surface of the object disposed on said susceptor arranged within said process chamber; and
   a heating device for heating the object to temperatures at which reaction films resulting from reaction between the oxide films formed on the surface of the object and the activated gas introduced into the process chamber are sublimated.
8. The processing apparatus according to item 7, characterized in that said activated gas forming device includes:
   a plasma generating device for converting the supplied gas into plasma;
   a gas supply device for supplying N₂ gas and H₂ gas into said plasma generating device;
   an activated species forming device for converting the plasma generated from the plasma generating device into activated species; and
   an activated gas forming device for supplying an NF₃ gas into the activated species of N₂ gas and H₂ gas formed in said activated species forming device so as to form activated gases of N₂ gas H₂ gas and NF₃ gas.
9. The processing apparatus according to item 7, characterized in that the oxide film formed on the surface of the object is a native oxide film formed by the reaction with the air atmosphere during the predetermined process steps applied to the object.
10. The processing apparatus according to item 9,
   characterized in that said activated gas forming device includes:
   a plasma generating device for converting the supplied gas into plasma;
   a gas supply device for supplying N₂ gas and H₂ gas into said plasma generating device;
   an activated species forming device for converting the plasma generated from the plasma generating device into activated species; and
   an activated gas forming device for supplying an NF₃ gas into the activated species of N₂ gas and H₂ gas formed in said activated species forming device so as to form activated gases of N₂ gas H₂ gas and NF₃ gas, and
   wherein the heating device for heating the object is for heating the object to temperatures at which the native oxide films formed on the surface of the object react with the activated gas introduced into the process chamber and the resultant reaction films are sublimated.
11. The processing apparatus according to item 10, characterized in that said plasma generating device is equipped with a mechanism for converting a gas into a plasma by utilizing a microwave.
12. The processing apparatus according to item 10,
   characterized in that said activated gas forming device includes:
   a pipe made of microwave transmitting materiel; and
   a supply section of a microwave and a supply section of a N₂ gas and H₂ gas formed at the inlet port of said pipe.
13. The processing apparatus according to item 10, characterized in that an introducing mechanism for introducing said activated gas onto the surface of the object disposed on the susceptor arranged in the process chamber includes a guide arranged at the outlet port of said activated species forming device for guiding the activated gases of the N₂ gas, H₂ gas and NF₃ gas onto the surface of the object.
14. The processing apparatus according to item 10, characterized in that those walls of said activated gas forming device, said introducing mechanism and said process chamber which are brought into contact with said activated gas are formed of an electrically insulating material.
15. The processing apparatus according to item 10, characterized in that said heating device heats said susceptor so as to elevate the temperature of the object disposed on the susceptor to temperatures at which said reaction films are sublimated.

## Claims

1. A processing apparatus for treating an object to be processed having an oxide film on a surface of the object, the processing apparatus comprising:
a gas introducing section for introducing plasma gas;
a plasma forming section which is connected to the gas introducing section and activates the plasma gas; and
a gas supply section which supplies added gas between the plasma forming section and the object to be processed,
the processing apparatus **characterized in that**:
the plasma forming section forms first active gas species by activating the plasma gas, the first active gas species being N* and H*;
the gas supply section forms second active gas species by adding the added gas to the first active gas species, the added gas including NF₃; and
the processing apparatus further comprises a device for introducing the second active gas species to the surface of the object to be processed, in which a product of a mixture of Si, N, H, F, O is formed on the object to be processed as the second active gas species reacts with the oxide film.

2. The processing apparatus according to claim 1, **characterized in that** the plasma gas is N₂ gas and H₂ gas.

3. The processing apparatus according to claim 1, **characterized in that** the added gas is NF₃ gas.

4. The processing apparatus according to claim 1, **characterized in that** the plasma forming section comprises a microwave generating source and a waveguide, and the plasma gas is activated by a microwave.

5. The processing apparatus according to claim 1, **characterized in that** the apparatus further comprises a heating means for heating the object to be processed on which the product is formed, and the oxide film is removed from the object to be processed by sublimating the product.

6. A method of treating an object to be processed having an oxide film on a surface of the object, the method comprising the steps of:
introducing plasma gas into a plasma forming section;
activating the introduced plasma gas in the plasma forming section; and
supplying added gas between the plasma forming section and the object to be processed,
the method **characterized in that**:
in the step of activating the plasma gas, first active gas species is formed by activating the plasma gas, the first active gas species being N* and H*;
in the step of supplying the added gas, second active gas species is formed by adding the added gas to the first active gas species, the added gas including NF₃; and
the method further includes the step of introducing the second active gas species to the surface of the object to be processed, the second active gas species reacting with the oxide, in which a product of a mixture of Si, N, H, F, O is formed on the object to be processed as the second active gas species reacts with the oxide film.

7. The method according to claim 7, **characterized in that** the gas for forming plasma is N₂ gas and H₂ gas.

8. The method according to claim 7, **characterized in that** the added gas is NF₃ gas.

9. The method according to claim 7, **characterized in that** the plasma forming section comprises a microwave generating source and a waveguide, and the gas for forming plasma is activated by a microwave.

10. The method according to claim 7, **characterized in that** the method further comprises the step of heating the object to be processed on which the product is formed, and the oxide film is removed from the object to be processed by sublimating the product.
